# EUROPÄISCHE PATENTSCHRIFT

(11) **EP 1 500 185 B1**
(45) Veröffentlichungstag und Bekanntmachung des Hinweises auf die Patenterteilung: **31.05.2006**
(21) Anmeldenummer: 03722270.0
(22) Anmeldetag: 10.04.2003
(51) Int. Cl.: H03D 7/14

(54) **INTEGRIERTE SCHALTUNG**
INTEGRATED CIRCUIT
CIRCUIT INTEGRE

(30) Priorität: 30.04.2002 DE 10219335
(43) Veröffentlichungstag der Anmeldung: 26.01.2005
(73) Patentinhaber: Infineon Technologies AG, 81669 München (DE)
(72) Erfinder: LANGENBERG, Jörg, 81829 München (DE); LIEBERMANN, Thomas, 81825 München (DE); SIMBÜRGER, Werner, 85540 Haar (DE); TIEBOUT, Marc, 81739 München (DE); WOHLMUTH, Hans-Dieter, 81735 München (DE)
(74) Vertreter: Viering, Jentschura & Partner
(86) Internationale Anmeldenummer: PCT/DE2003/001204
(87) Internationale Veröffentlichungsnummer: WO 2003/094339

(56) Entgegenhaltungen:
- EP-A- 0 166 626
- US-A- 5 361 409
- US-A- 5 826 183
- US-A1- 2002 032 016
- US-B1- 6 184 739

## Beschreibung

Die Erfindung betrifft eine integrierte Schaltung und insbesondere eine integrierte Schaltung mit einer Mischerschaltung.

Eine Mischerschaltung dient als Abwärtsmischer zur Frequenzumsetzung eines Hochfrequenzsignals (radio frequency = RF) in ein Zwischenfrequenzsignal (intermediate frequency = IF) oder als Aufwärtsmischer in umgekehrter Richtung, wobei ein Lokaloszillatorsignal (LO) zur Frequenzumsetzung verwendet wird. Dabei ergibt sich die Frequenz f_{IF} des Zwischenfrequenzsignals aus der Frequenz f_{RF} des Hochfrequenzsignals und der Frequenz f_{LO} des Lokaloszillatorsignals gemäß f_{IF} = f_{RF} ± f_{LO}. Als einfache Mischerschaltung kann schon eine elementare Multipliziererschaltung verwendet werden.

In einem modernen Mobilfunkgerät, beispielsweise in einem Mobiltelefon, welches in der Regel batteriebetrieben ist, wird üblicherweise eine elektronische Schaltung mit einer Mischerschaltung eingesetzt. Bei dieser elektronischen Schaltung ist ein spannungsgesteüerter Lokaloszillator vorgesehen, der neben einer maximierten Rauscharmut wegen des Batteriebetriebs einen minimierten Stromverbrauch sowie eine niedrige Betriebsspannung aufweisen sollte. Spannungsgesteuerte Lokaloszillatoren, welche auch als VCO (voltage controlled oscillator) bezeichnet werden, sind aus dem Stand der Technik, beispielsweise aus [1] bis [3], bekannt.

Die Mischerschaltung enthält für die Frequenzumsetzung ein nichtlineares Bauelement. Als nichtlineare Bauelemente können Dioden oder Transistoren benutzt werden.

Ein Transistormischer wird in der Regel aktiv betrieben, um mittels der Verstärkung des Transistors einen möglichst hohen Konversionsgewinn der Mischerschaltung zu erreichen. Ein Transistormischer kann auch passiv betrieben werden, wobei dann der Transistorkanal als regelbarer Widerstand benutzt wird.

Unter den Silizium-Bauelementen werden zur Zeit bipolare Transistoren bei den Mischeranwendungen auf Grund ihrer exponentiell verlaufenden nichtlinearen Strom-Spannungs-Kennlinie bevorzugt verwendet. Bei einer Mischerschaltung mit Feldeffekttransistoren auf der Basis von Metalloxid-Halbleitern (MOSFET = metal-oxide semiconductor field effect transistor) ergeben sich durch eine quadratische Funktion charakterisierte nichtlineare Strom-Spannungs-Kennlinien, wie dies in [4] beschrieben ist.

Die einfachste Form einer Mischerschaltung ist der Differenzverstärker, welcher nur in zwei Quadranten der Strom-Spannungs-Kennlinien multipliziert (siehe z.B. US 6 184 739 B1). Im Allgemeinen sind Mischerschaltungen jedoch symmetrisch aufgebaut, um in allen vier Quadranten der Strom-Spannungs-Kennlinien multiplizieren zu können. Dadurch wird eine exaktere Signalumsetzung erreicht.

Mischerschaltungen, welche mittels moderner Halbleitertechnik hergestellt werden und beispielsweise CMOS-Transistoren (CMOS = complementary metal-oxide semiconductor = komplementärer Metalloxid-Halbleiter) aufweisen, haben bei hohen umzusetzenden Frequenzen eine reduzierte Durchbruchsspannung. Folglich ist die maximal zulässige Betriebsspannung für die Mischerschaltung reduziert und beträgt gemäß dem Stand der Technik üblicherweise nur zwischen 0,9 V und 1,5 V. Da jeder Transistor einen Innenwiderstand aufweist, fällt bei Stromfluss durch einen Transistor an diesem eine gewisse Spannung ΔU ab. Um bei einer seriellen Aneinanderschaltung mehrerer Transistoren einen Stromfluss durch die Transistoren zu ermöglichen, muss somit die über alle Transistoren anliegende Betriebsspannung größer als die Summe der an den Transistoren abfallenden Spannungen ΔU sein. Wenn jedoch außer einem einzigen, sperrenden Transistor alle anderen Transistoren durchlässig sind, liegt die gesamte Betriebsspannung an dem sperrenden Transistor an. Deshalb sollte die Betriebsspannung kleiner als die niedrigste Durchbruchsspannung der Transistoren gewählt werden, um einen Spannungsdurchbruch in dem sperrenden Transistor zu vermeiden. Folglich begrenzt die Durchbruchspannung der Transistoren die zulässige Höhe der über alle Transistoren angelegten Betriebsspannung. Dies hat weiterhin zur Folge, dass beim Entwurf einer integrierten Schaltung mit mehreren in Serie geschalteten Transistoren die Anzahl der Transistoren begrenzt ist. Somit ist auch die Anzahl der stapelbaren Transistorebenen in einer integrierten Schaltung, d.h. die Anzahl der seriell hintereinandergeschalteten Transistoren, begrenzt, wobei anzumerken ist, dass mehrere Transistoren in verschiedenen Strompfaden auf gleicher Potentialstufe vorhanden sein können.

Gemäß dem Stand der Technik sind Mischerschaltungen bekannt, bei denen die Anzahl an Transistorebenen reduziert ist, jedoch nicht die Gesamtanzahl an Transistoren in der Mischerschaltung. Solche Mischerschaltungen sind unter der Bezeichnung "current-folded"-Mischerschaltung bekannt. Bei "current-folded"-Mischerschaltungen ist die Mischerschaltung derart in mehrere in geeigneter Weise miteinander elektrisch gekoppelte Teilschaltungen aufgeteilt, dass diese Teilschaltungen jeweils nur wenige, beispielsweise zwei, Transistorebenen aufweisen, wodurch die Betriebsspannung der Mischerschaltung reduziert werden kann. Die in geeigneter Weise miteinander elektrisch gekoppelten Teilschaltungen gewährleisten den gewünschten Signalfluss.

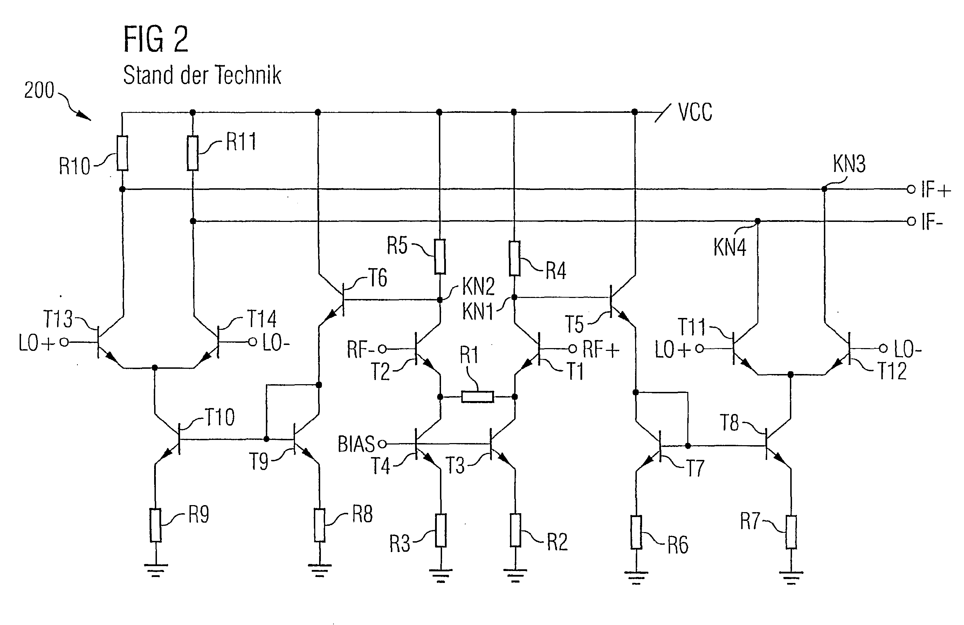

In Fig.2 ist eine bekannte "current-folded"-Mischerschaltung 200 gemäß dem Stand der Technik dargestellt, welcher es ermöglicht, dass trotz geringer Betriebsspannung mehr Transistoren als vorgesehene Transistorebenen eingesetzt werden können. Es handelt sich bei der in Fig.2 dargestellten "current-folded"-Mischerschaltung 200 um eine Vier-Quadranten-Mischerschaltung, welche auch unter der englischen Bezeichnung "current-folded double-balanced mixer" bekannt ist. Die Beschreibung "double-balanced" weist dabei darauf hin, dass das Lokaloszillatorsignal gleichmäßig an mehreren Stellen in der Mischerschaltung eingekoppelt wird.

In der "current-folded"-Mischerschaltung 200 werden ein Hochfrequenzsignal RF+ über die Basis eines ersten npn-Transistors T1 sowie das zum Hochfrequenzsignal RF+ invertierte Hochfrequenzsignal RF- über die Basis eines zweiten npn-Transistors T2 eingekoppelt. Die beiden npn-Transistoren T1, T2 sind emitterseitig mittels eines elektrischen Widerstandes R1 elektrisch miteinander gekoppelt. Der Emitter des npn-Transistors T1 bzw. T2 ist mit dem Kollektor eines steuernden dritten bzw. vierten npn-Transistors T3 bzw. T4 elektrisch gekoppelt. An der Basis des steuernden dritten bzw. vierten npn-Transistors T3 bzw. T4 liegt eine konstante Steuerspannung BIAS an und der Kollektor des steuernden dritten bzw. vierten npn-Transistors T3 bzw. T4 ist über einen elektrischen Widerstand R2 bzw. R3 mit dem Massepotential elektrisch gekoppelt. Die beiden npn-Transistoren T1, T2 sind kollektorseitig mittels eines elektrischen Widerstandes R4 bzw. R5 mit der Betriebsspannung VCC elektrisch gekoppelt.

Mit einem ersten Knoten KN1 zwischen dem elektrischen Widerstand R4 und dem Kollektor des ersten npn-Transistors T1 ist außerdem die Basis eines fünften npn-Transistors T5 elektrisch gekoppelt, dessen Kollektor ebenfalls mit der Betriebsspannung VCC elektrisch gekoppelt ist. Analog dazu ist mit einem zweiten Knoten KN2 zwischen dem elektrischen Widerstand R5 und dem Kollektor des zweiten npn-Transistors T2 die Basis eines sechsten npn-Transistors T6 elektrisch gekoppelt, dessen Kollektor wiederum mit der Betriebsspannung VCC elektrisch gekoppelt ist. Der Emitter des fünften npn-Transistors T5 ist mit dem Kollektor und parallel dazu mit der Basis eines siebten npn-Transistors T7 sowie mit der Basis eines achten npn-Transistors T8 elektrisch gekoppelt. Die Emitter der beiden npn-Transistoren T7, T8 sind jeweils über einen elektrischen Widerstand R6, R7 mit dem Massepotential elektrisch gekoppelt. In vergleichbarer Weise ist der Emitter des sechsten npn-Transistors T6 mit dem Kollektor und parallel dazu mit der Basis eines neunten npn-Transistors T9 sowie mit der Basis eines zehnten npn-Transistors T10 elektrisch gekoppelt. Die Emitter der beiden npn-Transistoren T9, T10 sind jeweils über einen elektrischen Widerstand R8, R9 mit dem Massepotential elektrisch gekoppelt.

An den Kollektor des achten bzw. zehnten npn-Transistors T8 bzw. T10 sind die Emitter zweier npn-Transistoren T11, T12 bzw. T13, T14 elektrisch gekoppelt. An den Basen der beiden npn-Transistoren T11, T13 liegt das Lokaloszillatorsignal LO+ an und an den Basen der beiden npn-Transistoren T12, T14 liegt das zum Lokaloszillatorsignal LO+ invertierte Lokaloszillatorsignal LO- an. Die beiden npn-Transistoren T11, T13 bzw. T12, T14 sind kollektorseitig miteinander und über jeweils einen elektrischen Widerstand R10 bzw. R11 mit der Betriebsspannung VCC elektrisch gekoppelt. An einem dritten Knoten KN3 zwischen den Kollektoren der beiden npn-Transistoren T12, T13 einerseits und dem elektrischen Widerstand R10 andererseits kann nun das Zwischenfrequenzsignal IF+ abgegriffen werden, während an einem vierten Knoten KN4 zwischen den Kollektoren der beiden npn-Transistoren T11, T14 einerseits und dem elektrischen Widerstand R11 andererseits das zu dem Zwischenfrequenzsignal IF+ invertierte Zwischenfrequenzsignal IF- abgegriffen werden kann.

Anschaulich stellt die "current-folded"-Mischerschaltung 200 einen horizontal aufgebauten Gilbert-Mischer dar. Die "current-folded"-Mischerschaltung 200 weist jedoch den Nachteil auf, dass die Stromspiegel innerhalb der "current-folded"-Mischerschaltung 200 im Allgemeinen langsam sind. Dies bedeutet, dass eine Veränderung des Hochfrequenzsignals RF+ (und damit auch des invertierten Hochfrequenzsignals RF-) eine zeitlich verzögerte Änderung des Zwischenfrequenzsignals IF+ (und auch des invertierten Zwischenfrequenzsignals IF-) verursacht. Folglich kann auf Grund der zeitlichen Verzögerung in der "current-folded"-Mischerschaltung 200 das Zwischenfrequenzsignal bei Umsetzung aus einem Hochfrequenzsignal eine Frequenz aufweisen, welche im Vergleich zur tatsächlich zu erzeugenden Zwischenfrequenz erheblich reduziert ist. Da dies unerwünscht ist, kann die "current-folded"-Mischerschaltung 200 nur mit geringen Betriebsfrequenzen betrieben werden, wenn eine zuverlässige Signalumsetzung sowie Signalübertragung erfolgen soll.

Der Erfindung liegt somit das Problem zugrunde, eine integrierte Schaltung anzugeben, bei der hochfrequente elektronische Signale gemischt werden können, obwohl die elektronische Schaltung mit gegenüber dem Stand der Technik reduzierter Betriebsspannung betrieben wird.

Das Problem wird durch eine integrierte Schaltung mit den Merkmalen gemäß dem unabhängigen Patentanspruch gelöst.

Eine integrierte Schaltung weist auf eine Mischerschaltung und einen Transformator, wobei die Mischerschaltung eine aktive Mischereinheit mit einer signalverstärkenden Einheit, zwei Referenzoszillator-Anschlüssen, zwei Hochfrequenz-Anschlüssen und zwei Zwischenfrequenz-Anschlüssen aufweist und wobei die integrierte Schaltung derart eingerichtet ist, dass der Transformator die zwei Hochfrequenz-Anschlüsse von der aktiven Mischereinheit galvanisch entkoppelt.

Anschaulich wirkt der Transformator somit als Trenntransformator. Dies hat den Vorteil, dass die aktive Mischereinheit ohne Belastung der Spannungen an den zwei Hochfrequenz-Anschlüssen in einer eigenständigen Stromkreis-Ebene betrieben werden kann.

Wenn die Mischerschaltung der integrierten Schaltung als Aufwärtsmischer verwendet wird, weist das signalverstärkende Element eine positive Verstärkungscharakteristik auf. Wird die Mischerschaltung der integrierten Schaltung jedoch als Abwärtsmischer verwendet, weist das signalverstärkende Element hingegen eine negative Verstärkungscharakteristik auf.

Ein Vorteil der integrierten Schaltung ist, dass die integrierte Schaltung mittels des Transformators an geeigneter Stelle in mehrere Schaltkreisabschnitte aufgeteilt wird. Jeder dieser Schaltkreisabschnitte kann somit separat mit der vollen Betriebsspannung versorgt werden. Somit kann mittels des Transformators die Betriebsspannung für die integrierte Schaltung auf die Hälfte der insgesamt benötigten Spannung reduziert werden.

Ein weiterer Vorteil der integrierten Schaltung ist, dass die integrierte Schaltung auch hochfrequente Signale ohne wesentlichen Informationsverlust umsetzen kann. Vorteilhaft ist außerdem, dass die integrierte Schaltung mittels Standardprozessen in der Halbleitertechnik hergestellt werden kann.

In einer bevorzugten Ausführungsform der integrierten Schaltung ist die signalverstärkende Einheit als Eingangsverstärker der aktiven Mischereinheit ausgebildet.

Die integrierte Schaltung weist bevorzugt eine Verstärkerschaltung zwischen den zwei Hochfrequenz-Anschlüssen und dem Transformator auf. Dies hat den Vorteil, dass die Betriebsspannungen in den einzelnen Schaltungsabschnitten weiter reduziert werden können.

Vorzugsweise weist die integrierte Schaltung mindestens ein Filterelement auf. Das Filterelement seinerseits weist bevorzugt eine Kaskode auf. Eine Kaskode reduziert parasitäre Kapazitäten und bietet somit den Vorteil, dass auch höhere Frequenzen in der integrierten Schaltung verarbeitet werden können und nicht unbeabsichtigt herausgefiltert werden. Zusätzlich oder alternativ kann das Filterelement einen Bandpassfilter aufweisen. Der Bandpassfilter ist bevorzugt mittels mindestens eines Kondensators verwirklicht.

In der integrierten Schaltung ist bevorzugt zwischen die zwei Hochfrequenz-Anschlüsse und den Transformator eine Kaskode geschaltet. Vorzugsweise ist auch zwischen den Transformator und die aktive Mischereinheit eine Kaskode geschaltet. Außerdem kann zwischen die aktive Mischereinheit und die zwei Zwischenfrequenz-Anschlüsse eine Kaskode geschaltet sein.

In einer bevorzugten Ausführungsform der integrierten Schaltung ist zwischen die aktive Mischereinheit und die zwei Zwischenfrequenz-Anschlüsse ein zusätzlicher Transformator geschaltet.

Vorzugsweise ist der Transformator ein monolithischer Transformator, welcher monolithisch auf dem Substrat, auf welcher die integrierte Schaltung vorgesehen ist, hergestellt wurde. Wenn ein zusätzlicher Transformator in der integrierten Schaltung vorgesehen ist, wird dieser bevorzugt ebenfalls monolithisch erzeugt.

Eine bevorzugte Ausführungsform der integrierten Schaltung weist ein Steuerelement zum Einstellen des Arbeitspunktes der integrierten Schaltung auf. Dieses Steuerelement ist dabei vorzugsweise ein steuerbares, induktives Bauteil.

In einer bevorzugten Ausführungsform der integrierten Schaltung weisen/weist die aktive Mischereinheit und/oder die Verstärkerschaltung und/oder die Kaskode mindestens einen Feldeffekttransistor auf. Anschaulich ist die integrierte Schaltung somit auf Transistorbasis aufgebaut.

Bei der Mischerschaltung der integrierten Schaltung kann es sich insbesondere um einen Gilbert-Mischer handeln.

Ausführungsbeispiele der Erfindung sind in den Figuren dargestellt und werden im Folgenden näher erläutert.

Es zeigen
- Figur 1: eine integrierte Schaltung gemäß einem ersten Ausführungsbeispiel der Erfindung;
- Figur 2: eine "current-folded"-Mischerschaltung gemäß dem Stand der Technik;
- Figur 3: eine integrierte Schaltung gemäß einem zweiten Ausführungsbeispiel der Erfindung; und
- Figur 4: eine perspektivische Draufsicht auf einen Transformator für die erfindungsgemäße integrierte Schaltung.

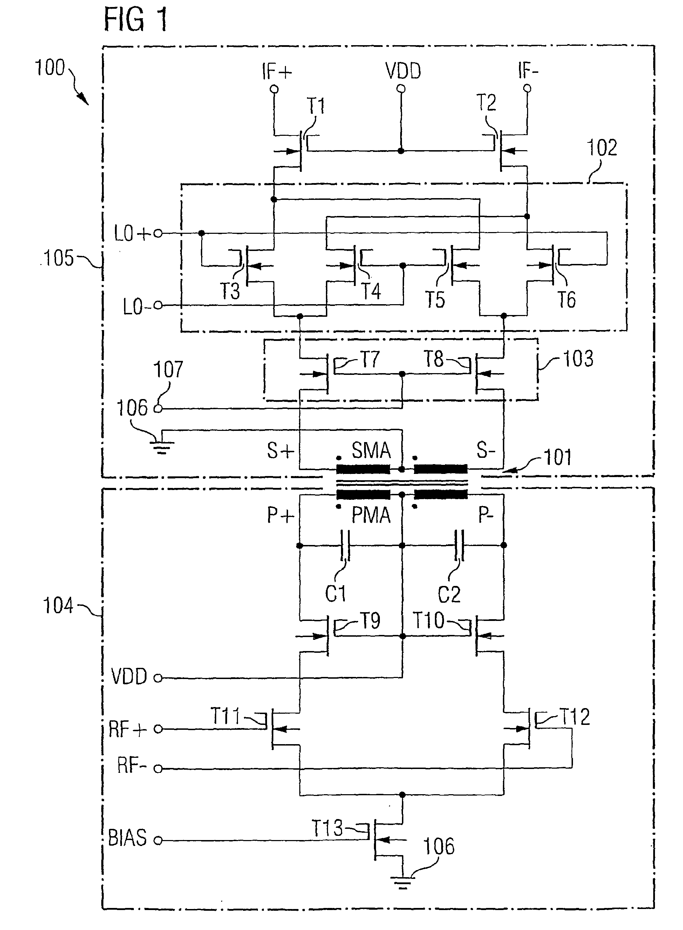

Fig.1 zeigt eine integrierte Schaltung 100 gemäß einem ersten Ausführungsbeispiel der Erfindung.

Die integrierte Schaltung 100 gemäß dem ersten Ausführungsbeispiel der Erfindung weist eine Mischerschaltung und einen Transformator 101 auf. Die Mischerschaltung weist seinerseits eine aktive Mischereinheit 102 mit einer signalverstärkenden Einheit 103, zwei Referenzoszillator-Anschlüsse LO+, LO-, zwei Hochfrequenz-Anschlüsse RF+, RF- und zwei Zwischenfrequenz-Anschlüsse IF+, IF- auf. Die integrierte Schaltung 100 ist dabei derart eingerichtet, dass der Transformator 101 die zwei Hochfrequenz-Anschlüsse RF+, RF- von der aktiven Mischereinheit 102 galvanisch entkoppelt.

Der Transformator 101 hat somit anschaulich die Funktion eines Trenntransformators. Gemäß dem Ausführungsbeispiel sind alle aktiven Bauelemente der integrierten Schaltung 100 mittels Feldeffekttransistoren (= FET) in 120 nm CMOS-Technologie verwirklicht. Außerdem ist die Mischerschaltung der integrierten Schaltung 100 gemäß dem HIPERLAN-Standard (HIPERLAN = high performance radio local area network = lokales Hochleistungsnetzwerk) sowie erfindungsgemäß als Gilbert-Mischer aufgebaut, mit welchem eine Frequenzumsetzung im Bereich von 17 GHz bis 20 GHz erreicht werden kann.

Anschaulich teilt der Transformator 101 die integrierte Schaltung 100 in einen ersten Schaltungsabschnitt 104 sowie einen zweiten Schaltungsabschnitt 105 auf. Dabei weist der erste Schaltungsabschnitt 104 die Primärseite des Transformators 101, zwei Hochfrequenz-Anschlüsse RF+, RF-, einen Masse-Anschluss 106, einen Betriebsspannungsanschluss VDD, einen Steuerspannungsanschluss BIAS sowie zwei Filterkondensatoren C1, C2, zwei Differenzverstärker T11, T12, zwei Verstärkerkaskoden T9, T10 und eine Steuerungseinheit T13 auf. Der zweite Schaltungsabschnitt 105 weist die Sekundärseite des Transformators 101, die aktive Mischereinheit 102, die signalverstärkende Einheit 103, die zwei Referenzoszillator-Anschlüsse LO+, LO-, die zwei Zwischenfrequenz-Anschlüsse IF+, IF-, einen Masse-Anschluss 106, einen Betriebsspannungsanschluss VDD, einen Verstärkerspannungsanschluss 107 sowie zwei Verstärkerkaskoden T1, T2 auf. Die aktive Mischereinheit 102 weist ihrerseits vier Mischertransistoren T3, T4, T5, T6 auf. Die signalverstärkende Einheit 103 weist hingegen zwei Verstärkerkaskoden T7, T8 auf.

Die sechs Verstärkerkaskoden T1, T2, T7, T8, T9, T10, die vier Mischertransistoren T3, T4, T5, T6, die zwei Differenzverstärker T11, T12 und die Steuerungseinheit T13 sind gemäß dem Ausführungsbeispiel mittels Feldeffekttransistoren (= FET) in CMOS-Technologie verwirklicht.

Die Gate-Elektrode der Steuerungseinheit T13 ist mit dem Steuerspannungsanschluss BIAS elektrisch gekoppelt. In Abhängigkeit von der anliegenden, meist konstanten, Steuerspannung kann der Kanalbereich der Steuerungseinheit T13 durchlässig oder sperrend gemacht werden. Dadurch lässt sich der Arbeitspunkt der integrierten Schaltung 100 genau einstellen. Die Steuerungseinheit T13 kann als Alternative statt mittels eines FET auch mittels eines steuerbaren, induktiven Bauteils verwirklicht werden. Als steuerbares, induktives Bauteil kann beispielsweise eine integrierte Spule verwendet werden, welche mittels geeigneter Veränderung ihrer Windungszahl steuerbar und im Detail beispielsweise in [5] beschrieben ist. Die Source-Elektrode der Steuerungseinheit T13 ist mit dem Masse-Anschluss 106 des ersten Schaltungsabschnitts 104 elektrisch gekoppelt. Die Drain-Elektrode der Steuerungseinheit T13 ist mit den Source-Elektroden der zwei Differenzverstärker T11, T12 elektrisch gekoppelt.

Mittels der zwei Hochfrequenz-Anschlüsse RF+, RF- kann ein Hochfrequenzsignal über RF+ sowie das zu dem Hochfrequenzsignal invertierte Hochfrequenzsignal über RF- an die Gate-Elektroden der beiden Differenzverstärker T11, T12 angelegt und somit in die integrierte Schaltung 100 eingekoppelt werden. Die Drain-Elektrode des Differenzverstärkers T11 bzw. T12 ist mit der Source-Elektrode der Verstärkerkaskode T9 bzw. T10 elektrisch gekoppelt. Die beiden Verstärkerkaskoden T9, T10 dienen einer Reduzierung der an den beiden Differenzverstärkern T11, T12 auftretenden Miller-Kapazitäten und somit zur Erhöhung der Durchlässigkeit für elektrische Signale mit hohen Frequenzen. Somit erhöhen die beiden Verstärkerkaskoden T9, T10 die Zuverlässigkeit der beiden Differenzverstärker T11, T12.

Die Drain-Elektrode der Verstärkerkaskode T9 bzw. T10 ist elektrisch mit der Sekundärseite eines Filterkondensators C1 bzw. C2 sowie mit dem primären Positivanschluss P+ bzw. dem primären Negativanschluss P- des Transformators 101 gekoppelt. Der primäre Mittenanschluss PMA des Transformators 101 ist mit den Primärseiten der beiden Filterkondensatoren C1, C2, mit den Gate-Elektroden der beiden Verstärkerkaskoden T9, T10 sowie mit dem Betriebsspannungsanschluss VDD elektrisch gekoppelt. Zwischen den primären Positivanschluss P+ und den primären Mittenanschluss PMA des Transformators 101 ist eine primäre Positivwicklung elektrisch eingekoppelt, während zwischen den primären Mittenanschluss PMA und den primären Negativanschluss P- des Transformators 101 eine primäre Negativwicklung elektrisch eingekoppelt ist.

Die Verstärkerkaskode T9 bzw. T10 bildet zusammen mit dem Filterkondensator C1 bzw. C2 sowie der primären Positivwicklung bzw. der primären Negativwicklung jeweils eine Filtereinheit, welche als Bandpass-Filter wirkt. Dabei kann die Filtercharakteristik dieser Filtereinheit mittels der am Betriebsspannungsanschluss VDD anliegenden Betriebsspannung gesteuert werden.

Beim Anliegen eines Hochfrequenzsignals am ersten Schaltungsabschnitt 104 sowie entsprechend durchgeschalteter Steuerungseinheit T13, durchgeschaltetem Differenzverstärker T11 bzw. T12 sowie durchgeschalteter Verstärkerkaskode T9 bzw. T10 in dem ersten Schaltungsabschnitt 104 liefert die Sekundärseite des Transformators 101 einen Strom in die Verstärkerkaskode T7 bzw. T8 und somit in den zweiten Schaltungsabschnitt 105. Dazu ist der sekundäre Mittenanschluss SMA des Transformators 101 elektrisch mit dem Massepotential gekoppelt, während der sekundäre Positivanschluss S+ des Transformators 101 mit der Source-Elektrode der Verstärkerkaskode T7 und der sekundäre Negativanschluss S- des Transformators 101 mit der Source-Elektrode der Verstärkerkaskode T8 elektrisch gekoppelt ist.

Die Gate-Elektroden der beiden Verstärkerkaskoden T7, T8 sind mit einem Verstärkerspannungsanschluss 107 elektrisch gekoppelt. Der Verstärkerspannungsanschluss 107 ermöglicht die Steuerung der Verstärkercharakteristik der beiden Verstärkerkaskoden T7, T8 mittels einer anliegenden, geeigneten Verstärkerspannung. Die Drain-Elektrode der Verstärkerkaskode T7 bzw. T8 ist mit den Source-Elektroden der beiden Mischertransistoren T3, T4 bzw. T5, T6 elektrisch gekoppelt. Die vier Mischertransistoren T3, T4, T5, T6 bilden die aktive Mischereinheit 102, während die beiden Verstärkerkaskoden T7, T8 die signalverstärkende Einheit 103 bilden, welche somit einen Eingangsverstärker für die aktive Mischereinheit 102 darstellt. Die signalverstärkende Einheit 103 reduziert unerwünschte parasitäre Kapazitäten an den Source-Elektroden der vier Mischertransistoren T3, T4, T5, T6, wodurch eine höhere Resonanzfrequenz in dem Transformator 101 und letztendlich eine höhere Betriebsfrequenz der elektronischen Schaltung 100 erreicht werden kann.

Die Gate-Elektroden der beiden Mischertransistoren T3, T6 sind elektrisch mit dem Referenzoszillator-Anschluss LO+ gekoppelt, während die Gate-Elektroden der beiden Mischertransistoren T4, T5 elektrisch mit dem zum Referenzoszillator-Anschluss LO+ invertierten Referenzoszillator-Anschluss LO- gekoppelt sind. Der Referenzoszillator-Anschluss LO+ ermöglicht das Einkoppeln eines Referenzoszillatorsignals in die aktive Mischereinheit 102, während der invertierte Referenzoszillator-Anschluss LO- das Einkoppeln des zu dem Referenzoszillatorsignal invertierten Referenzoszillatorsignals in die aktive Mischereinheit 102 ermöglicht.

Die Drain-Elektroden der beiden Mischertransistoren T3, T5 bzw. T4, T6 sind elektrisch miteinander sowie mit der Source-Elektrode einer Verstärkerkaskode T1 bzw. T2 gekoppelt. Die Drain-Elektrode der Verstärkerkaskode T1 ist elektrisch mit dem Zwischenfrequenz-Anschluss IF+ gekoppelt, während die Drain-Elektrode der Verstärkerkaskode T2 elektrisch mit dem zu dem Zwischenfrequenz-Anschluss IF+ invertierten Zwischenfrequenz-Anschluss IF- gekoppelt ist. Die Gate-Elektroden der beiden Verstärkerkaskoden T1, T2 sind mit dem Betriebsspannungsanschluss VDD elektrisch gekoppelt. Entsprechend der über den Betriebsspannungsanschluss VDD eingekoppelten Betriebsspannung dienen die beiden Verstärkerkaskoden T1, T2 einer Verstärkung der Signale zwischen den beiden Mischertransistoren T3, T5 bzw. T4, T6 und dem entsprechenden Zwischenfrequenz-Anschluss IF+ bzw. IF-. Dadurch reduzieren die beiden Verstärkerkaskoden T1, T2 die maximalen Spannungen zwischen den Gate-Elektroden und den Drain-Elektroden der vier Mischertransistoren T3, T4, T5, T6, wodurch eine höhere Betriebszuverlässigkeit für die elektronische Schaltung 100 erreicht wird.

Folglich können in der elektronischen Schaltung 100 im Vergleich zum Stand der Technik die Betriebsspannung reduziert und gleichzeitig eine Frequenzumsetzung bei höchsten Frequenzen erreicht werden.

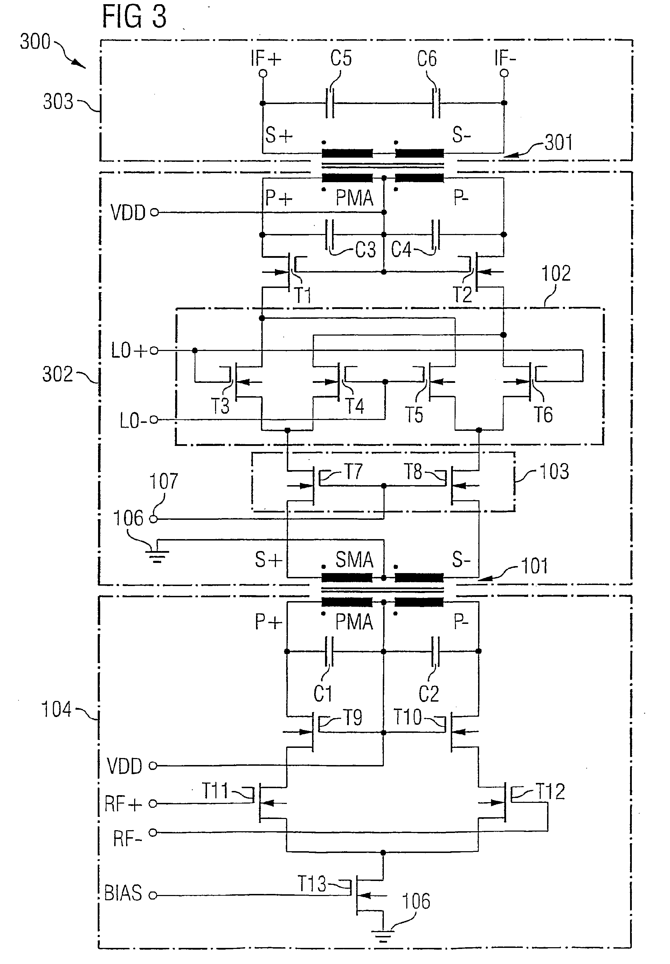

In Fig.3 ist eine integrierte Schaltung 300 gemäß einem zweiten Ausführungsbeispiel der Erfindung dargestellt.

Die integrierte Schaltung 300 gemäß dem zweiten Ausführungsbeispiel der Erfindung unterscheidet sich nur geringfügig von der integrierten Schaltung 100 gemäß dem ersten Ausführungsbeispiel der Erfindung. Deshalb sind gleiche Komponenten mit gleichen Bezugszeichen bezeichnet. Auf gleiche Komponenten, welche für die integrierte Schaltung 100 gemäß dem ersten Ausführungsbeispiel bereits beschrieben wurden, wird deshalb nicht erneut eingegangen. Für diese Komponenten sei auf die Beschreibung zu Fig.1 verwiesen.

Die integrierte Schaltung 300 des zweiten Ausführungsbeispiels unterscheidet sich im Wesentlichen dadurch von der integrierten Schaltung 100 des ersten Ausführungsbeispiels, dass zwischen der aktiven Mischereinheit 102 und den Zwischenfrequenz-Anschlüssen IF+, IF- ein zusätzlicher Transformator 301 vorgesehen ist. Gemäß dem zweiten Ausführungsbeispiel sind sowohl der Transformator 101 als auch der zusätzliche Transformator 301 monolithisch in die integrierte Schaltung 300 integriert. Der zusätzliche Transformator 301 ermöglicht eine zusätzliche Reduzierung der Betriebsspannung für die integrierte Schaltung 300 und funktioniert anschaulich als Trenntransformator. Folglich wird der zweite Schaltungsabschnitt 105 des ersten Ausführungsbeispiels durch den zweiten Schaltungsabschnitt 302, 303 des zweiten Ausführungsbeispiels ersetzt. Dabei sind der zweite Schaltungsabschnitt 302, 303 des zweiten Ausführungsbeispiels und der zweite Schaltungsabschnitt 105 des ersten Ausführungsbeispiels zwischen dem Transformator 101 und den Source-Elektroden der beiden Verstärkerkaskoden T1, T2 identisch.

Der zweite Schaltungsabschnitt (302, 303) des zweiten Ausführungsbeispiels weist zusätzlich den zusätzlichen Transformator 301 sowie zwei Filterkondensatoren C3, C4 auf.

Die Drain-Elektrode der Verstärkerkaskode T1 bzw. T2 ist elektrisch mit der Sekundärseite des Filterkondensators C3 bzw. C4 sowie mit dem primären Positivanschluss P+ bzw. dem primären Negativanschluss P- des zusätzlichen Transformators 301 gekoppelt. Der primäre Mittenanschluss PMA des zusätzlichen Transformators 301 ist mit den Primärseiten der beiden Filterkondensatoren C3, C4, mit den Gate-Elektroden der beiden Verstärkerkaskoden T1, T2 sowie mit dem Betriebsspannungsanschluss VDD elektrisch gekoppelt. Zwischen den primären Positivanschluss P+ und den primären Mittenanschluss PMA des zusätzlichen Transformators 301 ist eine primäre Positivwicklung elektrisch eingekoppelt, während zwischen den primären Mittenanschluss PMA und den primären Negativanschluss P- des zusätzlichen Transformators 301 eine primäre Negativwicklung elektrisch eingekoppelt ist.

Die Verstärkerkaskode T1 bzw. T2 bildet zusammen mit dem Filterkondensator C3 bzw. C4 sowie der primären Positivwicklung bzw. der primären Negativwicklung jeweils eine Filtereinheit, welche als Bandpass-Filter wirkt. Dabei kann die Filtercharakteristik dieser Filtereinheit mittels der am Betriebsspannungsanschluss VDD anliegenden Betriebsspannung gesteuert werden.

Beim Ausgeben eines Zwischenfrequenzsignals aus der aktiven Mischereinheit 102 sowie entsprechend durchgeschalteter Verstärkerkaskode T1 bzw. T2 in dem zweiten Schaltungsabschnitt (302, 303) des zweiten Ausführungsbeispiels liefert die Sekundärseite des zusätzlichen Transformators 301 einen Strom an die zwei Zwischenfrequenz-Anschlüsse IF+, IF-. Dazu ist der sekundäre Positivanschluss S+ des zusätzlichen Transformators 301 mit dem Zwischenfrequenz-Anschluss IF+ sowie mit der Sekundärseite des Filterkondensators C5 und der sekundäre Negativanschluss S- des zusätzlichen Transformators 301 mit dem zu dem Zwischenfrequenz-Anschluss IF+ invertierten Zwischenfrequenz-Anschluss IF- sowie mit der Sekundärseite des Filterkondensators C6 elektrisch gekoppelt. Außerdem sind die Primärseiten der Filterkondensatoren C5, C6 elektrisch miteinander gekoppelt.

Gemäß dem zweiten Ausführungsbeispiel ist der Transformator 101 für eine maximal zu übertragende Frequenz von 20 GHz ausgelegt, während der zusätzliche Transformator 301 für eine maximal zu übertragende Frequenz von 2 GHz ausgelegt ist.

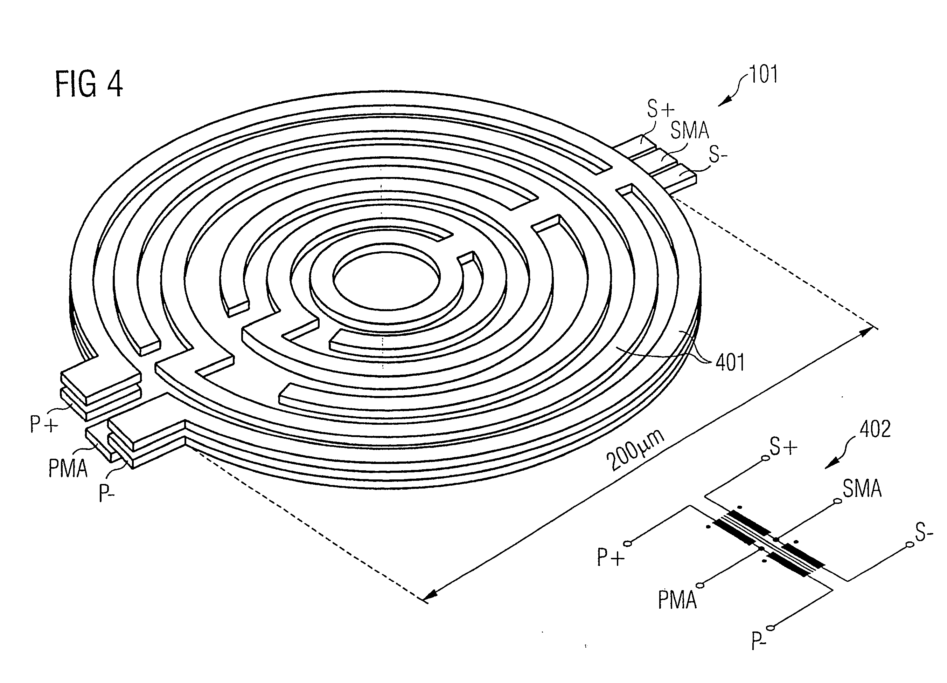

Fig.4 zeigt einen Transformator 101 für die erfindungsgemäßen integrierten Schaltungen 100, 300.

Der Transformator 101, und in analoger Weise der zusätzliche Transformator 301, ist monolithisch hergestellt und weist eine spiralförmige Anordnung von Windungen 401 auf, welche im Wesentlichen in zwei parallelen Ebenen liegen und einen Außendurchmesser von rund 200 µm aufweisen. Ein solcher monolithischer Transformator ist im Detail in [6] beschrieben.

Zusätzlich ist in Fig.4 das dem Transformator 101 entsprechende Ersatzschaltbild 402 in gleicher Orientierung wie der Transformator 101 dargestellt.

Im Übrigen sei darauf hingewiesen, dass der Transformator 301 insbesondere mittels eines Transformators 101 verwirklicht sein kann, bei dem lediglich der sekundäre Mittenanschluss SMA elektrisch unkontaktiert bleibt.

In diesem Dokument sind folgende Veröffentlichungen zitiert:
[1] Cranickx J., Steyaert M.S.J.: "A 1.8-GHz Low-Phase-Noise CMOS VCO Using Optimized Hollow Spiral Inductors" in IEEE J. of Solid-State Circuits, Vol. 32, No. 5, pp. 736-744 (1997)
[2] Zannoth M., Kolb B., Fenk J., Weigel R.: "A Fully Integrated VCO at 2 GHz" in IEEE J. of Solid-State Circuits, Vol. 33, No. 12, pp. 1987-1991 (1998)
[3] Tiebout M.: "Low-Power Low-Phase-Noise Differentially Tuned Quadrature VCO Design in Standard CMOS" in IEEE J. of Solid-State Circuits, Vol. 36, No. 7, pp. 1018-1024 (2001)
[4] Meinke H.H., Grundlach F.W.: "Taschenbuch der Hochfrequenztechnik" Springer Verlag, 5. Auflage, Band 1, S. G18-G21 (1992)
[5] DE-Patentanmeldung, amtliches Aktenzeichen 101 62 263.5, Anmelder: Infineon Technologies AG, Erfinder: Tiebout M.
[6] Simbürger W., Wohlmuth H.D., Weger P., Heinz A.: "A Monolithic Transformer Coupled 5-W Silicon Power Amplifier with 59% PAE at 0.9 GHz" in IEEE J. of Solid-State Circuits, Vol. 34, No. 12, pp. 1881-1892 (1999)

### Bezugszeichenliste

- 100: Integrierte Schaltung gemäß erstem Ausführungsbeispiel der Erfindung
- 101: Transformator
- 102: aktive Mischereinheit
- 103: signalverstärkende Einheit
- 104: erster Schaltungsabschnitt
- 105: zweiter Schaltungsabschnitt
- 106: Masse-Anschluss
- 107: Verstärkerspannungsanschluss
- RF+: Hochfrequenz-Anschluss
- RF-: invertierter Hochfrequenz-Anschluss
- LO+: Referenzoszillator-Anschluss
- LO-: invertierter Referenzoszillator-Anschluss
- IF+: Zwischenfrequenz-Anschluss
- IF-: invertierter Zwischenfrequenz-Anschluss
- BIAS: Steuerspannungsanschluss
- VDD: Betriebsspannungsanschluss
- T1 bis T13: Feldeffekttransistor in CMOS-Technologie
- T1, T2: Verstärkerkaskode
- T7 bis T10: Verstärkerkaskode
- T3 bis T6: Differenzverstärker
- T11, T12: Differenzverstärker
- T13: Steuerungseinheit
- C1, C2: Filterkondensator
- PMA: primärer Mittenanschluss von Transformator 101
- SMA: sekundärer Mittenanschluss von Transformator 101
- P+: primärer Positivanschluss von Transformator 101
- P-: primärer Negativanschluss von Transformator 101
- S+: sekundärer Positivanschluss von Transformator 101
- S-: sekundärer Negativanschluss von Transformator 101
- 200: "Current-folded"-Mischer gemäß dem Stand der Technik
- RF+: Hochfrequenzsignal
- RF-: invertiertes Hochfrequenzsignal
- LO+: Lokaloszillatorsignal
- LO-: invertiertes Lokaloszillatorsignal
- IF+: Zwischenfrequenzsignal
- IF-: invertiertes Zwischenfrequenzsignal
- BIAS: konstante Steuerspannung
- VCC: Betriebsspannung
- T1 bis T14: npn-Transistor
- R1 bis R11: elektrischer Widerstand
- KN1 bis KN4: Knoten
- 300: Integrierte Schaltung gemäß zweitem Ausführungsbeispiel der Erfindung
- 301: zusätzlicher Transformator
- (302, 303): zweiter Schaltungsabschnitt
- C3 bis C6: Filterkondensator
- 401: spiralförmige Windungen
- 402: Ersatzschaltbild für Transformator 101

## Patentansprüche

1. Integrierte Schaltung (100, 300)
• mit einer Mischerschaltung, welche einen ersten Schaltkreisabschnitt (104) und einen zweiten Schaltkreisabschnitt aufweist (105; 302, 303), und
• mit einem Transformator (101)
• wobei der erste Schaltkreisabschnitt eine Schaltung mit zwei Hochfrequenz-Anschlüsse (RF+, RF-) aufweist,
• wobei der zweite Schaltkreisabschnitt zwei Referenzoszillator-Anschlüsse (LO+, LO-), eine aktive Mischereinheit (102) mit einer signalverstärkenden Einheit (103) und zwei Zwischenfrequenz-Anschlüsse (IF+, IF-) aufweist,
• wobei die aktive Mischereinheit (102) und die signalverstärkende Einheit (103) einen gemeinsamen Strompfad aufweisen, und
• wobei die integrierte Schaltung derart eingerichtet ist, dass der Transformator 101 die zwei Hochfrequenz-Anschlüsse (RF+, RF-) von der aktiven Mischereinheit galvanisch entkoppelt und dass der Transformator den ersten Schaltkreisabschnitt (104) und den zweiten Schaltkreisabschnitt (105; 302, 303) derart zusammenkoppelt, dass jeder der beiden Schaltkreisabschnitte separat mit der vollen Betriebsspannung (VDD) der integrierten Schaltung versorgt wird.

2. Integrierte Schaltung gemäß Anspruch 1,
bei welcher die signalverstärkende Einheit (103) ein Eingangsverstärker der aktiven Mischereinheit (102) ist.

3. Integrierte Schaltung gemäß einem der Ansprüche 1 bis 2, welche eine Verstärkerschaltung (T9-T12) zwischen den zwei Hochfrequenz-Anschlüssen und dem Transformator aufweist.

4. Integrierte Schaltung gemäß einem der Ansprüche 1 bis 3, welche mindestens ein Filterelement (C1, C2, T9, T10; C3, C4, T1, T2) aufweist.

5. Integrierte Schaltung gemäß Anspruch 4,
bei welcher das Filterelement eine Kaskode (T9, T10; T1, T2) aufweist.

6. Integrierte Schaltung gemäß Anspruch 4 oder 5,
bei welcher das Filterelement einen Bandpassfilter aufweist.

7. Integrierte Schaltung gemäß Anspruch 6,
bei welcher der Bandpassfilter durch mindestens einen Kondensator (C1-C4) verwirklicht ist.

8. Integrierte Schaltung gemäß einem der Ansprüche 1 bis 7,
bei welcher zwischen die zwei Hochfrequenz-Anschlüsse und den Transformator eine Kaskode (T9, T10) geschaltet ist.

9. Integrierte Schaltung gemäß einem der Ansprüche 1 bis 8,
bei welcher zwischen den Transformator und die aktive Mischereinheit eine Kaskode (T7, T8) geschaltet ist.

10. Integrierte Schaltung gemäß einem der Ansprüche 1 bis 9,
bei welcher zwischen die aktive Mischereinheit (102) und die zwei Zwischenfrequenz-Anschlüsse eine Kaskode (T1, T2) geschaltet ist.

11. Integrierte Schaltung gemäß einem der Ansprüche 1 bis 10,
bei welcher der Transformator (101) ein monolithischer Transformator (401) ist.

12. Integrierte Schaltung gemäß einem der Ansprüche 1 bis 11,
bei welcher zwischen die aktive Mischereinheit (102) und die zwei Zwischenfrequenz-Anschlüsse ein zusätzlicher Transformator (301) geschaltet ist.

13. Integrierte Schaltung gemäß Anspruch 12,
bei welcher der zusätzliche Transformator (103) ein monolithischer Transformator (401) ist.

14. Integrierte Schaltung gemäß einem der Ansprüche 1 bis 13, welche ein Steuerelement (T13) zum Einstellen des Arbeitspunktes der integrierten Schaltung aufweist.

15. Integrierte Schaltung gemäß Anspruch 14,
bei welcher das Steuerelement ein steuerbares, induktives Bauteil ist.

16. Integrierte Schaltung gemäß einem der Ansprüche 1 bis 15,
bei welcher die aktive Mischereinheit und/oder die Verstärkerschaltung und/oder die Kaskode mindestens einen Feldeffekttransistor aufweisen/aufweist.

17. Integrierte Schaltung gemäß einem der Ansprüche 1 bis 16,
bei welcher die Mischerschaltung ein Gilbert-Mischer ist.

## Claims

1. An integrated circuit (100, 300)
• having a mixer circuit, which has a first circuit section (104) and a second circuit section (105; 302, 303), and
• having a transformer (101),
• the first circuit section having a circuit with two radiofrequency terminals (RF+, RF-),
• the second circuit section having two reference oscillator terminals (LO+, LO-), an active mixer unit (102) with a signal-amplifying unit (103) and two intermediate frequency terminals (IF+, IF-),
• the active mixer unit (102) and the signal-amplifying unit (103) having a common current path, and
• the integrated circuit being set up in such a way that the transformer (101) directly electrically decouples the two radiofrequency terminals (RF+, RF-) from the active mixer unit and that the transformer couples the first circuit section (104) and the second circuit section (105; 303, 304) together in such a way that each of the two circuit sections is separately supplied with the full operating voltage (VDD) of the integrated circuit.

2. The integrated circuit as claimed in claim 1,
in which the signal-amplifying unit (103) is an input amplifier of the active mixer unit (102).

3. The integrated circuit as claimed in one of claims 1 to 2,
which has an amplifier circuit (T9-T12) between the two radiofrequency terminals and the transformer.

4. The integrated circuit as claimed in one of claims 1 to 3,
which has at least one filter element (C1, C2, T9, T10; C3, C4, T1, T2).

5. The integrated circuit as claimed in claim 4,
in which the filter element has a cascade (T9, T10; T1, T2).

6. The integrated circuit as claimed in claim 4 or 5,
in which the filter element has a bandpass filter.

7. The integrated circuit as claimed in claim 6,
in which the bandpass filter is realized by at least one capacitor (C1-C4).

8. The integrated circuit as claimed in one of claims 1 to 7,
in which a cascode (T9, T10) is connected between the two radiofrequency terminals and the transformer.

9. The integrated circuit as claimed in one of claims 1 to 8,
in which a cascode (T7, T8) is connected between the transformer and the active mixer unit.

10. The integrated circuit as claimed in one of claims 1 to 9,
in which a cascode (T1, T2) is connected between the active mixer unit (102) and the two intermediate frequency terminals.

11. The integrated circuit as claimed in one of claims 1 to 10,
in which the transformer (101) is a monolithic transformer (401).

12. The integrated circuit as claimed in one of claims 1 to 11,
in which an additional transformer (301) is connected between the active mixer unit (101) and the two intermediate frequency terminals.

13. The integrated circuit as claimed in claim 12,
in which the additional transformer (103) is a monolithic transformer (401).

14. The integrated circuit as claimed in one of claims 1 to 13,
which has a control element (T13) for setting the operating point of the integrated circuit.

15. The integrated circuit as claimed in claim 14,
in which the control element, is a controllable inductive component.

16. The integrated circuit as claimed in one of claims 1 to 15,
in which the active mixer unit and/or the amplifier circuit and/or the cascode have/has at least one field effect transistor.

17. The integrated circuit as claimed in one of claims 1 to 16,
in which the mixer circuit is a Gilbert mixer.

## Revendications

1. Circuit (100 ; 300) intégré
• ayant un circuit mélangeur qui a une première partie (104) de circuit et une deuxième partie (105 ; 302, 303) de circuit ; et
• un transformateur (101)
• dans lequel la première partie de circuit a un circuit ayant deux bornes (RF+ ; RF-) de haute fréquence ;
• dans lequel la deuxième partie de circuit a deux bornes (LO+, LO-) d'oscillateur de référence, une unité (102) active de mélangeur ayant une unité (103) d'amplification du signal et deux bornes (IF+, IF-) de fréquence intermédiaire ;
• dans lequel l'unité (102) active de mélangeur et l'unité (103) d'amplification du signal ont un trajet de courant commun ; et
• dans lequel le circuit intégré est tel que le transformateur (101) découple galvaniquement les deux bornes (RF+, RF-) de haute fréquence de l'unité active de mélangeur et que le transformateur accouple, ensemble, la première partie (104) de circuit et la deuxième partie (105 ; 302, 303) de circuit de façon à ce que chacune des deux parties de circuit soit alimentée séparément par la pleine tension (VDD) de fonctionnement du circuit intégré.

2. Circuit intégré suivant la revendication 1,
dans lequel l'unité (103) d'amplification du signal est un amplificateur d'entrée de l'unité (102) active de mélangeur.

3. Circuit intégré suivant l'une des revendications 1 à 2,
qui a un circuit (T9 à T12) amplificateur entre les deux bornes de haute fréquence et le transformateur.

4. Circuit intégré suivant l'une des revendications 1 à 3,
qui a au moins un élément (C1, C2 ; T9, T10 ; C3, C4 ; T1, T2) de filtre.

5. Circuit intégré suivant la revendication 4,
dans lequel l'élément de filtre a une cascode (T9, T10 ; T1, T2).

6. Circuit intégré suivant la revendication 4 ou 5,
dans lequel l'élément de filtre a un filtre passe-bande.

7. Circuit intégré suivant la revendication 6,
dans lequel le filtre passe-bande est réalisé par au moins un condensateur (C1 à C4).

8. Circuit intégré suivant l'une des revendications 1 à 7,
dans lequel il est monté une cascode (T9, T10) entre les deux bornes de haute fréquence et le transformateur.

9. Circuit intégré suivant l'une des revendications 1 à 8,
dans lequel il est monté une cascode (T7, T8) entre le transformateur et l'unité active de mélangeur.

10. Circuit intégré suivant l'une des revendications 1 à 9,
dans lequel il est monté une cascode (T1, T2) entre l'unité (102) active de mélangeur et les deux bornes de fréquence intermédiaire.

11. Circuit intégré suivant l'une des revendications 1 à 10,
dans lequel le transformateur (101) est un transformateur (401) monolithique.

12. Circuit intégré suivant l'une des revendications 1 à 11,
dans lequel il est monté un transformateur (301) supplémentaire entre l'unité (102) active de mélangeur et les deux bornes de fréquence intermédiaire.

13. Circuit intégré suivant la revendication 12,
dans lequel le transformateur (103) supplémentaire est un transformateur (401) monolithique.

14. Circuit intégré suivant l'une des revendications 1 à 13,
qui a un élément (T13) de commande pour régler le point de travail du circuit intégré.

15. Circuit intégré suivant la revendication 14,
dans lequel l'élément de commande est un composant inductif qui peut être commandé.

16. Circuit intégré suivant l'une des revendications 1 à 15,
dans lequel l'unité active de mélangeur et/ou le circuit d'amplification et/ou la cascode a ou ont au moins un transistor à effet de champ.

17. Circuit intégré suivant l'une des revendications 1 à 16,
dans lequel le circuit mélangeur est un mélangeur Gilbert.
